# EUROPÄISCHE PATENTSCHRIFT

(11) **EP 2 633 560 B1**
(45) Veröffentlichungstag und Bekanntmachung des Hinweises auf die Patenterteilung: **13.12.2017**
(21) Anmeldenummer: 11784590.9
(22) Anmeldetag: 26.10.2011
(51) Int. Cl.: F24J 2/52, H02S 20/20

(54) **PHOTOVOLTAIKMODUL MIT SCHUTZSCHEIBE**
PHOTOVOLTAIC MODULE HAVING A PROTECTIVE DISK
MODULE PHOTOVOLTAÏQUE COMPORTANT UNE VITRE DE PROTECTION

(30) Priorität: 29.10.2010 DE 102010050052
(43) Veröffentlichungstag der Anmeldung: 04.09.2013
(73) Patentinhaber: Adensis GmbH, 01129 Dresden (DE)
(72) Erfinder: BECK, Bernhard, 97332 Volkach OT Dimbach (DE)
(74) Vertreter: Bauer, Daniel
(86) Internationale Anmeldenummer: PCT/EP2011/005395
(87) Internationale Veröffentlichungsnummer: WO 2012/055547

(56) Entgegenhaltungen:
- WO-A1-2009/086150
- DE-A1-102008 009 608
- DE-U1-202007 008 659
- DE-U1-202008 002 264
- DE-U1-202009 014 048
- US-A1- 2003 070 368
- US-A1- 2010 237 029
- US-A1- 2010 263 724

## Beschreibung

Die Erfindung betrifft ein rechteckförmiges Photovoltaikmodul mit einer ersten Außenfläche aus Glas und einer zweiten eine Feuchtigkeitssperre bildende Außenfläche aus Kunststoff. Die Rechteckform soll dabei inhärent das Vorhandensein von zwei Längskanten und zwei Querkanten einschließen.
Es sind Module bekannt, welche ohne einen Rahmen mittels Klammern (üblicherweise 4 Stück / Modul) montiert werden. Jedoch ist hierbei immer zwingend sowohl die vordere als auch die hintere Scheibe vollflächig in Glas auszuführen, um die über die Klammer einwirkenden Kräfte so zu verteilen, dass die Kunststoffschicht zwischen beiden Glasscheiben vor Verletzung geschützt wird. Diese Bauform hat jedoch den Nachteil, dass aufgrund der Doppelglasscheiben das Gewicht sehr hoch ist und damit die Handhabbarkeit eingeschränkt wird. US 2003/070368A offenbart ein rechteckförmiges rahmenloses Photovoltaikmodul mit den Merkmalen des Oberbegriffs des Anspruchs 1. Aus der US 2010/0263724 A1 ist ein gerahmtes Photovoltaikmodul bekannt, welches wie bei vielen Modulen dieses Typs üblich, eine ausgespritzte Silikonnaht zwischen dem Rahmen und der Glaskante des Modulscheibenaufbaus aufweist. Während des Einspritzvorgangs müssen die Teile in einer fixierten Relation zueinander stehen, was durch Abstandshalter geschieht. Die Abstandshalter sind in einem regelmäßigen Abstand angeordnet und in einer erheblichen Menge vorgesehen. Dieses ist für den Zweck der gleichmäßigen Fixierung beim Einbringen der Silikonnaht erforderlich und auch zweckmäßig.
Aus der WO 2009/086150 A1 ist eine Modulklammer bekannt, die für rahmenlose Module geeignet ist. Die Klammern haben einen im Wesentlichen U-förmigen Elastomereinsatz, von denen ein Schenkel an der oberen und der andere Schenkel an der unteren Glasscheibe anliegt. Es wurde die Beobachtung gemacht, dass sich bei der Montage der PV-Module diese Einsätze verschieben oder lösen können. Um dieses zu vermeiden ist der Elastomereinsatz an dem Klammergrundkörper befestigen, insbesondere verklebt.

Aus der GB 2 456 166 ist ein Photovoltaikmodul bekannt, dessen Oberseite aus einer Glasscheibe besteht und dessen Unterseite aus einer Aluminiumplatte besteht. Es sind Schutzelemente beschrieben, die dazu dienen, die verletzlichen Glasränder und Glasecken der Glasscheibe zu schützen. Die vorgesehen Schutzscheiben sind auch als L- oder U-förmige Teile ausgestaltet, wobei ein Schenkel zwischen der Aluminiumplatte und einer ersten Schutzschicht angeordnet ist.

Ferner ist es aus der DE 20 2007 008 659 U1 ein Kantenschutzprofil bekannt, wie es in Verbindung mit Photovoltaikmodulen eingesetzt wird. Dort ist eine U-förmige Klammer beschrieben, die mit einem Lamellenprofil und einer Dichtlippe versehen ist. Zwischen die Schenkel des U's wird das Photovoltaikmodul eingeschoben und durch den Lammelleneffekt hält die Klammer rutschsicher am Modul.

Module der eingangs genannten Art sind z.B. aus der Druckschrift DE 20 2009 016 735 A1 bekannt und haben den in der Figur 1 gezeigten prinzipiellen Aufbau. Eine Glasscheibe bildet die der Sonne zugewandte erste Außenfläche 1. Die dem Boden zugewandte zweite Außenfläche 3 ist aus einem Kunststoff gefertigt, z.B. Tedlar. Zwischen den beiden Außenflächen 1,3 befindet sich eine Isolierschicht 5, in welche Photovoltaikzellen 7 eingebettet sind. Die PV-Zellen 7 sind über nicht gezeigte elektrische Verbindungen miteinander verbunden. Von den Längskanten 9 erstreckt sich ein Randbereich 11, in welchem keine Photovoltaikzellen 5 verbaut sind. Module dieser Bauart sind in der Regel mit einem Rahmen umgeben, der die Außenkanten (Längs- und/oder Querkanten), insbesondere die Kunststoffschicht 3 vor einer Beschädigung schützen. Diese Rahmung ist teuer und kann Nachteile bei der Funktion des Moduls nach sich ziehen. Laubblätter, Äste und dergleichen können hängenbleiben und eine PV-Zelle 7 abdecken. Dies führt zu einem Ausfall des gesamten Moduls, da die Zellen 7 elektrisch in Reihe geschaltet sind.

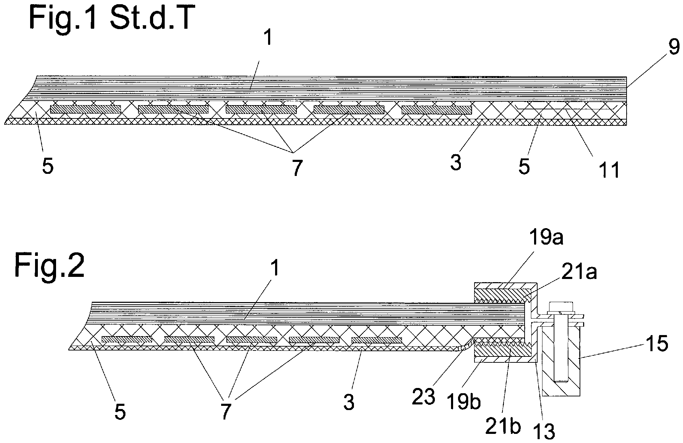

Die Erfindung geht aus von der Überlegung, dass sich bei einem Weglassen der Rahmung Nachteile bezüglich der Lebensdauer des PV-Moduls ergeben können, wie es anhand der Figur 2 dargestellt ist und im Folgenden erläutert wird. Die Module werden mittels vier Klammern 13 an einen Modulträgerholm 15 einer nicht weiter gezeigten Unterkonstruktion für die Photovoltaikanlage befestigt. Die Klammer 13 weist zwei Klemmbacken 19a, 19b auf, deren Innenseite mit jeweils zwei Gummipuffern 21a, 21b belegt sind. Der erste Gummipuffer 21a liegt auf der Glasfläche 1 auf und der zweite Gummipuffer 21b auf der Kunststofffläche 3.

Durch Windlast, die eine Schwingung mit Durchbiegen der PV-Module verursacht, kann es über die Betriebsjahre zu einem Schmirgelvorgang kommen, der die Isolationsschicht 5 in die Kunststoffaußenfläche 3 eindrückt, wie es der Übersichtlichkeit halber stark übertrieben in der Figur 2 gezeigt ist. Es kommt zu Spannungsrissen, wie sie durch Pfeile 23 angedeutet sind. Diese Verletzung der Kunststoffaußenfläche 3 führt zu einem Eindringen von Feuchtigkeit, die die Isolierschicht 5 zersetzt und die aufgrund von sich einstellenden Kurzschlüssen zu einer Minderleistung oder gar einem Ausfall des PV-Moduls führen kann.

Ausgehend von diesen Überlegungen hat es sich die Erfindung zur Aufgabe gestellt, bei einem Modultyp der genannten Art die Rahmung wegzulassen und dennoch zu erwartende Nachteile zu vermeiden. Gleichzeitig soll der mit den Doppelglasscheibenmodulen einhergehende günstige Einsatz von einfachen, gummilosen Montageklammern ermöglicht werden.

Diese Aufgabe wird erfindungsgemäß dadurch gelöst, dass auf der Kunststoffaußenfläche je zumindest eine, einen vorgebbaren Klemmbereich bedeckende Schutzscheibe fest mit der Kunststoffaußenfläche verbunden ist. Dabei geht die Schutzscheibe insbesondere von den beiden Längskanten der Kunststoffaußenfläche aus.

Die Kunststoffaußenfläche wird in der Regel durch die Unterseite einer Kunststofffolie gebildet, deren Oberseite den Photovoltaikzellen und der Glasscheibe zugewandt ist. Die Oberseite grenzt also an die Isolierschicht an, wohingegen die Unterseite frei bleibt, bis auf den Bereich der Schutzscheibe. Anstelle einer Kunststofffolie kann auch jedes andere Kunststoffteil verwendet werden, um die Kunststoffaußenfläche zu bilden. So z.B. kann wie eine dünne Kunststoffschicht auf einem Trägermaterial aufgebracht sein oder direkt auf der Isolierschicht aufgebracht werden, oder es kann eine dünne Kunststoffplatte oder dergleichen verwendet werden. Wichtig ist die in Relation zum Glas verhältnismäßig leichte Ausführung der untersten Lage des Laminats, dessen Schichtverbund als Ganzes das Photovoltaikmodul bildet.

Durch die feste Verbindung zur Kunststoffaußenfläche wird der zu erwartende Schmirgeleffekt mit seinem Abrieb und seiner Bildung von Kratzern und Rissen verlagert auf einen Schmirgelvorgang zwischen der Schutzscheibe und dem Gummipuffer. Die Kunststoffoberfläche der Feuchtigkeitssperrschicht bleibt unverletzt und hält ihre Funktion bei.

Photovoltaikmodule haben von den Herstellern vorgegebene Bereiche, an welchen die Klammern anzusetzen sind. Bei dem üblichen Einsatz von vier Klemmstellen pro Modul befinden sich die Klemmbacken in der Regel an den Längskanten der PV-Module nach ca. einem Viertel der Längskantenlänge und die andere ca. nach einem Dreiviertel der Längskantenlänge auf jeder Seite. In diesem Bereich sind die Schutzscheiben fest mit dem Photovoltaikmodul verbunden. Wenn vorliegend von Bereich oder Klemmbereich die Rede ist, so ist nicht der unmittelbar von den Klemmbacken ausgeübte Druckbereich unterhalb der Klemmbacken gemeint, sondern ein über diesen Druckbereich hinausreichender Bereich. So erstreckt sich die Schutzscheibe vorzugsweise über die doppelte bis vierfache Fläche um die eigentliche Klemmfläche unterhalb der Klammerbacken herum. Es ist auch möglich, die beiden Schutzscheiben an derselben Längskante des Photovoltaikmoduls durch eine einzige, sich über beide vom Hersteller empfohlene Klemmbereiche erstreckende Schutzscheibe zu ersetzen. Die dann einzige Schutzscheibe pro Längskante kann auch über die empfohlenen Klemmbereiche hinausgehen und sich z.B. sogar über die gesamte Längskante erstrecken. Zur Erzielung eines sanften Abbaus der eingeleiteten Klemmkraft sind die Ränder der Schutzscheibe an den drei Seiten abgeschrägt, an denen die Schutzscheibe auf die Kunststoffaußenfläche montiert ist. Dabei kommen als Verbindungstechniken insbesondere eine Verklebung oder eine Verschweißung infrage.

Ein geeignetes Material für die Schutzscheibe ist Stahl, Aluminium, Karbon, Teflon oder ein Hartkunststoff. Auch Glas oder Keramik sind verwendbar. Das Material sollte härter sein als das, welches für die Gummipuffer verwendet wird, um bei einer Durchbiegung des PV-Moduls, z.B. bei Sturm, ein Gleiten des Gummipuffers auf der Schutzscheibe zu gewährleisten.

Die naheliegende Art der Montage des Photovoltaikmoduls sieht vor, dass es mittels einer zwei Klemmbacken umfassenden Modulklammer, deren einer Klemmbacken auf die Schutzscheibe und deren anderer Klemmbacken auf die Glasscheibe platziert ist, an einer Unterkonstruktion befestigt ist. Eine neue Befestigungsart wird durch das erfindungsgemäße PV-Modul ermöglicht, indem es mittels einer einen einzigen Klemmbacken aufweisenden Modulklammer an einer Unterkonstruktion befestigt ist, wobei die Schutzscheibe unmittelbar auf der Unterkonstruktion aufliegt. So kommen noch Einsparungen bei der Auslegung und dem Materialaufwand der Modulklammer zum Tragen.

Bei der zuvor genannten Variante kann es nützlich sein, die erfindungsgemäße Schutzscheibe mit Ausgestaltungen zu versehen, die weitere Funktionen zulassen. So kann die Schutzscheibe einen senkrecht abstehenden Dorn aufweisen, der in eine Aussparung eines Modulträgerholms der Unterkonstruktion eingeführt ist, und der das Photovoltaikmodul gegen ein Verrutschen sichert. Dies ermöglicht das Auflegen von PV-Modulen auf eine größere Fläche, ohne sie mittels der Modulklammern zu fixieren oder auch nur die Modulklammer vorerst zu platzieren. Anschließend können die Modulklammern bei einer größeren Anzahl an Modulen gesetzt und verschraubt werden. Ein lästiges Wechseln des Werkzeugs oder ein Weglegen des Schraubwerkzeugs nach jedem verlegten PV-Modul ist obsolet.

Eine andere Zusatzfunktion ergibt sich, wenn die Schutzscheibe zwei parallel verlaufende Stege aufweist, deren Abstand der Breite eines Modulträgerholms der Unterkonstruktion entspricht. Diese Maßnahme vereinfacht ein Ausrichten der PV-Module zur Erzielung eines Feldes an gleich beabstandet ausgerichteten PV-Modulen.

Weiterhin ist es vorteilhaft, wenn zwischen der Schutzscheibe und der Längskante des rechteckförmigen Moduls ein Abstand zwischen 2 mm und 20 mm eingehalten wird. Diese Maßnahme vermeidet einen Stau von Regenwasser zwischen der Klammer und dem Modul an der für die Langzeitstabilität kritischen Verklebungskante.

Schließlich kann eine andere Zusatzfunktion durch eine über die Längskante der Kunststoffschicht hinausragende Nase an der Schutzscheibe erreicht werden. Die Nase dient als Führungshilfe, wenn die Module in eine Stapelbox verfrachtet werden, die seitlich eine Transport-Schichtungsschiene aufweist. Dies ermöglicht einen nicht Richtungs-gebundenen Transport der Box, der ansonsten nötig ist, um eine Beschädigung von Modulen zu vermeiden.

Weitere Vorteile und Ausgestaltungen der Erfindung ergeben sich aus der Beschreibung eines Ausführungsbeispiels anhand der Figuren. Es zeigen:
- Fig. 1: Prinzipieller Aufbau eines Photovoltaikmoduls nach dem Stand der Technik mit weggelassenem Rahmen;
- Fig. 2: Erläuterungsskizze zur Schädigung des PV-Moduls bei Weglassen des Rahmens durch Klammereinwirkung;
- Fig. 3: Aufsicht auf die Rückseite eines erfindungsgemäßen PV-Moduls;
- Fig. 4: Einen Schnitt entlang der Linie IV - IV der Figur 3 mit Darstellung einer ersten Ausführungsform einer verwendeten Klammer;
- Fig. 5: Einen Schnitt entlang der Linie IV - IV der Figur 3 mit Darstellung einer zweiten Ausführungsform einer verwendeten Klammer;
- Fig. 6: Einen Schnitt entlang der Linie IV - IV der Figur 3 mit Darstellung einer zweiten Ausführungsform einer verwendeten Schutzscheibe;
- Fig. 7: Einen Schnitt entlang der Linie IV - IV der Figur 3 mit Darstellung einer dritten Ausführungsform einer verwendeten Schutzscheibe;
- Fig. 8: Eine Ansicht mit Darstellung einer Ausführungsform der Schutzscheibe ohne Modul mit einer Abtropfrundung ;
- Fig. 9: Einen Schnitt entlang der Linie VI - VI der Figur 3 mit einem Zentrierdorn; und
- Fig. 10: Einen Schnitt entlang der Linie VI - VI der Figur 3 mit zwei Zentrierstegen.

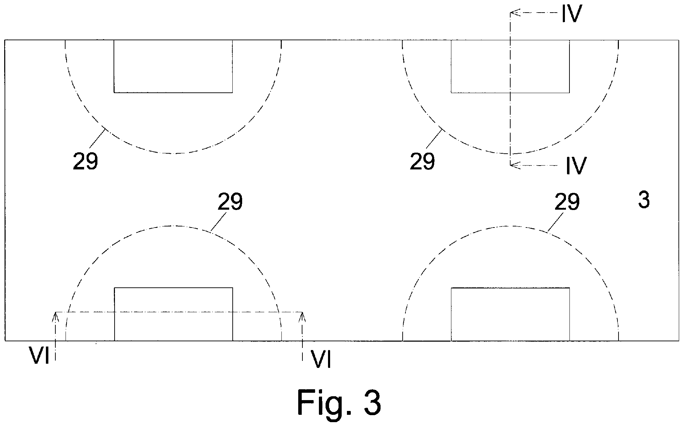

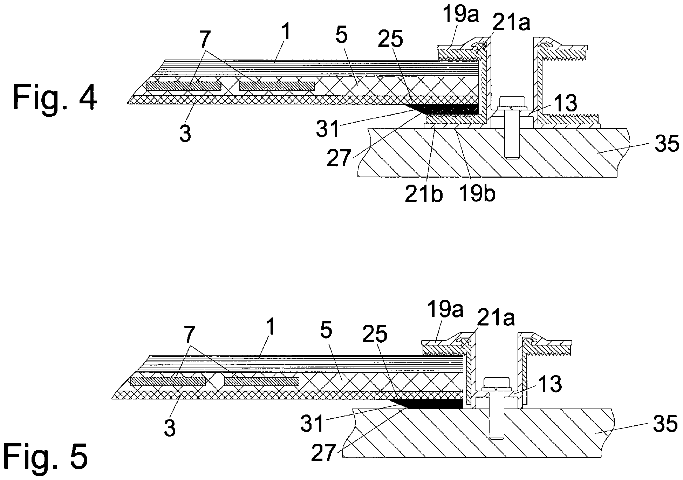

In den Figuren 3 und 4 ist die Unterseite eines, eine Längskante 9 aufweisenden, rechteckförmigen PV-Moduls mit seiner die zweite Außenfläche 3 bildenden Kunststoffschicht gezeigt, die insbesondere eine Kunststofffolie sein kann. Über eine Klebeschicht 25 sind vier Pads, die auch als Schutzlage oder auch Schutzscheibe 27 bezeichnet werden, fest und dauerhaft mit der Kunststoffaußenfläche 3 verbunden. Die Schutzscheiben 27 sind dabei zwischen 0,5 mm und 2 mm dick und tragen kaum zur Gesamtbauhöhe des Moduls auf. Die vier Schutzscheiben 27 sind innerhalb der von dem Hersteller der Module vorgegebenen Klammerbereiche 29, die durch eine gepunktete Linie angedeutet sind, vorgesehen. Die Klammerbereiche 29 befinden sich ca. nach einem Viertel und einem Dreiviertel der Längskante 24, um eine gleichmäßige Kraftverteilung zu erreichen, und um eine Verbiegung des Moduls bei Windlast möglichst klein zu halten.

Am rechten Rand der Figur 4 ist eine Klammer 13 gezeigt, die einen ersten und einen zweiten Klemmbacken 19a, bzw. 19b hat, an welche jeweils ein Gummipuffer 21a, 21b zum Schutz des Moduls vor Beschädigungen durch die Klemmbacken 19a, 19b aufweist. Das Pad oder die Schutzscheibe 27 hat drei Kanten, die eine Schräge 31 aufweisen, die einen weichen Kraftübergang zwischen dem zweiten Gummipuffer 21b und der Schutzscheibe 27 sicher stellen. Dieser Kraftübergang einerseits und die Verbindung zwischen der Klebeschicht 25 und der Kunststoffaußenfläche 3 andererseits müssen so ausgelegt sein, dass die Scherkräfte, die bei einem Schwingen des Photovoltaikmoduls zwischen den Klemmbacken 19a, 19b auftreten, zu einem Schmirgel- oder Verschiebungseffekt zwischen dem zweiten Gummipuffer 21b und der Schutzscheibe 27 führen, ohne dass die Scherkräfte eine Bewegung zwischen der Schutzscheibe 27 und der Kunststoffaußenfläche 3 bewirken. Auf diese Weise behütet die Schutzscheibe 27 die Kunststoffaußenseite vor Verletzungen, wie sie in der Figur 2 beispielhaft illustriert sind.

Die Figur 5 zeigt die Anordnung nach der Figur 4 mit einer Klammer 13, die nur einen einzigen Klemmbacken 19a aufweist. Die Schutzscheibe 27 liegt dann unmittelbar an einem zur Unterkonstruktion gehörigen Modultragholm 35 an. Die zuvor bezüglich der Scherkräfte gemachten Aussagen bleiben gültig, wobei jetzt der Reibungsbeiwert zwischen der Schutzscheibe 27 und dem Modultragholm 35 so ausgelegt sein muss, dass er kleiner ist als der durch die Verbindung 25 bereitgestellt Reibungsbeiwert zwischen der Kunststoffaußenfläche 3 und der Schutzscheibe 17. Mit anderen Worten, zuerst müssen Scherkräfte durch eine Verschiebung oder einen Versatz zwischen Schutzscheibe 27 und Modulträgerholm 35 abgebaut werden, bevor die Scherkräfte einen Versatz oder ein Schmirgeln zwischen der Kunststoffaußenfläche 3 und der Schutzscheibe 27 bewirken.

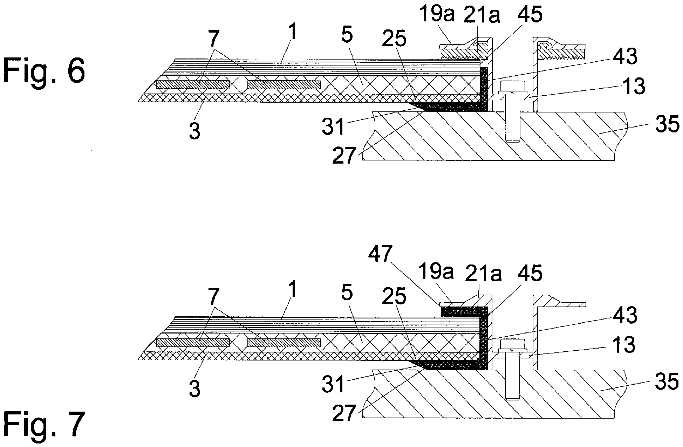

Die Figur 6 zeigt eine zweite Ausführungsform einer Schutzscheibe 27, die sich von der in den vorhergehenden Figuren gezeigte dadurch unterscheidet, dass sie klammerseitig um die Kante des Photovoltaikmoduls herumgeführt ist. Die Schutzscheibe 27 weist somit einen rechtwinklig weggeführten Fortsatz 43 auf, der nach der Montage des PV-Moduls zwischen der Klammer 13 und dem Modulrand 45 platziert ist und der die empfindliche Laminat-Stirnfläche schützt. Im Ergebnis ist die Schutzscheibe 27 also zu einem Winkelteil ergänzt, wobei die Schutzscheibe 27 von einem Schenkel des Winkelteils gebildet wird.

Die Figur 7 zeigt als dritte Ausführungsform die Schutzscheibe 27 mit dem Fortsatz 43 und einem weiteren Schenkel 47, der parallel zur Schutzscheibe 27 geführt ist. So wird ein U-Profil gebildet, welches im Bereich der Klammern die Funktion eines Rahmenteils übernimmt. Diese Variante ermöglicht es, auf den Einbau eines Gummipuffers gänzlich zu verzichten.

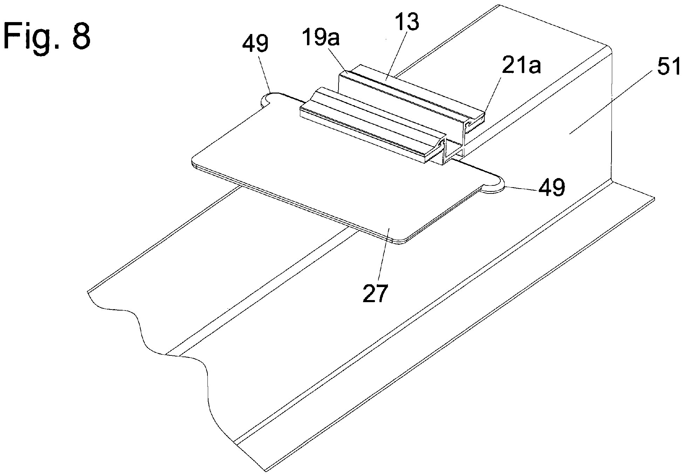

Schließlich ist in der Figur 8 noch eine vierte Ausführungsform einer Schutzscheibe gezeigt, welche mit zwei Abtropfrundungen 49 versehen ist. Die Abtropfrundungen 49 dienen als Wasserableitblech, welches Regenwasser und die mitgeführten Verschmutzungen nach außerhalb des Klammerbereichs umleitet. Diese Maßnahme ist beim Einsatz einer Hutschiene 51 aus verzinktem Stahlblech als Modulträger sinnvoll, um Korrosionspunkte zu vermeiden.

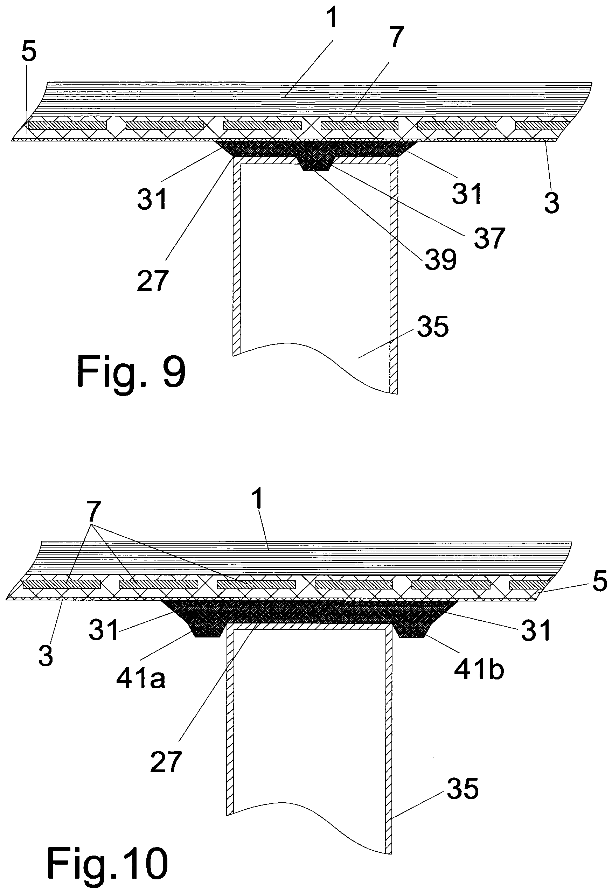

Die Figur 9 zeigt einen Schnitt entlang der Linie VI - VI der Figur 3 mit einer einen Zentrierdorn 37 aufweisenden Schutzscheibe 27, der auch länglich oder als Steg ausgelegt sein kann. Der Zentrierdorn 37 hat eine Abmessung von wenigen Millimetern, um ihn in eine entsprechend angepasste Aussparung 39 einzuführen. Die Aussparung 39 befindet sich in dem Modulträgerholm 35. In dem Modulträgerholm 35 sind eine Vielzahl dieser Aussparungen 39 entsprechend dem Rastermaß, mit dem die PV-Module verbaut sind, vorgesehen. Mindestens zwei der Schutzscheiben 27 pro Modul, dann insbesondere die sich diagonal gegenüberliegenden, sind mit einem solchen Zentrierdorn 37 ausgestattet. Die Zentrierdorne 37 sichern zusätzlich zur Modulklammer 13 die Unverrutschbarkeit der PV-Module, wobei sie es ermöglichen, dass die Modulklammer 13 mit geringerer Kraft montiert werden kann, da sie nur noch gegen ein Abheben der PV-Module von dem Modulträgerholm 35 sichern muss. Die Verrutschbarkeit wird durch die Zentrierdorne 37 sicher verhindert.

Eine andere Zentrierhilfe ist in der Figur 10 dargestellt. Dort sind zwei von der Schutzscheibe 27 ausgehende Stege 41a, 41b gezeigt, deren Abstand A voneinander an die Breite des Modulträgerholms 35 angepasst ist. Die Anpassung sieht so aus, dass die Innenseiten der Stege 41a, 41b formschlüssig an die Kanten des Modulträgerholms 35 anliegen. Die beiden Stege 41a, 41b sichern so das auf die Holme 35 aufgelegte PV-Modul gegen ein Verdrehen und dienen somit ebenfalls insbesondere der Montagehilfe.

Schließlich sei noch eine Nase (nicht gezeigt) erwähnt, die von der Schutzscheibe 27 seitlich nach außen weg ragt. Die Nase dient der Erleichterung beim Transport der PV-Module, indem sie in eine formmäßig angepasste Führungsschiene eingefädelt werden kann, welche sich an einer Wand der Transportbox befindet.

### Bezugszeichenliste

- 1: Glasaußenfläche
- 3: Kunststofffolie mit Kunststoffaußenfläche
- 5: Isolierschicht
- 7: Photovoltaikzelle
- 9: Längskante
- 11: Randbereich
- 13: Modulklammer
- 15, 35: Modulträgerholm
- 19a, 19b: Klemmbacken
- 21a, 21b: Gummipuffer
- 23: Spannungsrisspfeile
- 25: Klebeschicht
- 27: Schutzscheibe
- 29: Klammerbereich
- 31: Schräge
- 35: Modulträgerholm
- 37: Zentrierdorn
- 39: Aussparung
- 41a, 41b: Steg
- 43: Fortsatz
- 45: PV-Modulrand
- 47: weiterer Schenkel
- 49: Abtropfrundung

## Patentansprüche

1. Rechteckförmiges, rahmenloses Photovoltaikmodul mit einer ersten Außenfläche (1) aus Glas und mit einer zweiten eine Feuchtigkeitssperre bildende Außenfläche (3) aus Kunststoff, wobei auf der Außenfläche (3) aus Kunststoff an beiden Längskanten (9), insbesondere von ihnen ausgehend, je zumindest eine, einen vorgebbaren Klemmbereich bedeckende Schutzscheibe (27) fest und dauerhaft mit der Kunststoffaußenfläche (3) verbunden ist, **dadurch gekennzeichnet, dass** die Schutzscheibe (27) aus Stahl, Aluminium, Karbon, Teflon, Hartkunststoff, Glas oder Keramik besteht.

2. Photovoltaikmodul nach Anspruch 1, **dadurch gekennzeichnet, dass** pro Längskante (9) zwei Schutzscheiben (27) vorgesehen sind, von denen eine ca. nach einem Viertel der Längskantenlänge und die andere ca. nach einem Dreiviertel der Längskantenlänge platziert ist.

3. Photovoltaikmodul nach Anspruch 1 oder 2, **dadurch gekennzeichnet, dass** die Ränder der Schutzscheibe (27) zumindest teilweise abgeschrägt sind.

4. Photovoltaikmodul nach einem der Ansprüche 1 bis 3, **dadurch gekennzeichnet, dass** die Schutzscheibe (27) an beiden Ecken ihrer der Modulkante (9) zugewandten Längskante mit einer Wasserabtropfanformung (49) versehen ist.

5. Photovoltaikmodul nach einem der Ansprüche 1 bis 4, **dadurch gekennzeichnet, dass** es mittels einer zwei Klemmbacken (19a,19b) umfassenden Modulklammer (13), deren einer Klemmbacken (19b) auf die Schutzscheibe (27) und deren anderer Klemmbacken (19a) auf die Glasscheibe (1) platziert ist, an einer Unterkonstruktion befestigt ist.

6. Photovoltaikmodul nach einem der Ansprüche 1 bis 4, **dadurch gekennzeichnet, dass** es mittels einer eine einzige Klemmbacke (19a) aufweisenden Modulklammer (13) an einer Unterkonstruktion befestigt ist, wobei die Schutzscheibe (27) unmittelbar auf der Unterkonstruktion aufliegt.

7. Photovoltaikmodul nach Anspruch 6, **dadurch gekennzeichnet, dass** die Schutzscheibe (27) einen senkrecht abstehenden Zentrierdorn (37) aufweist, der in eine Aussparung (39) eines Modulträgerholms (35) der Unterkonstruktion eingeführt ist, und der das Photovoltaikmodul gegen ein Verrutschen sichert.

8. Photovoltaikmodul nach Anspruch 6 oder 7, **dadurch gekennzeichnet, dass** die Schutzscheibe (27) zwei parallel verlaufende Stege (41a, 41b) aufweist, deren Abstand (A) voneinander der Breite eines Modulträgerholms (35) der Unterkonstruktion entspricht.

9. Photovoltaikmodul nach einem der Ansprüche 1 bis 8, **dadurch gekennzeichnet, dass** zwischen der Schutzscheibe (27) und der Längskante (9) ein Abstand zwischen 2 mm und 20 mm eingehalten wird.

## Claims

1. Rectangular frameless photovoltaic module with a first outer surface (1) of glass and a second outer surface (3) of plastic forming a moisture barrier, wherein at least one protective disc (27) covering a predetermined clamping region and permanently connected to the plastic outer surface (3) is formed on both the longitudinal edges (9) of the plastic outer surface (3), and respectively goes outwards from them, **characterized in that** the protective disc (27) is made of steel, aluminum, carbon, Teflon, hard plastic, glass or ceramic.

2. Photovoltaic module according to claim 1, **characterized in that** two protective discs (27) are provided per longitudinal edge (9), one of which is placed at a quarter of the longitudinal edge length, while the other is placed at three-quarters of the longitudinal edge length.

3. Photovoltaic module according to claim 2, **characterized in that** the edges of the protective disc (27) are at least partly beveled.

4. Photovoltaic module according to one of the claims 1 to 3, **characterized in that** the protective disc (27) is provided with a water draining molding (49) at both corners of its longitudinal edge facing the module edge (9).

5. Photovoltaic module according to one of the claims 1 to 4, **characterized in that** it is fastened to a substructure by means of a module clamp (13) comprising two clamping jaws (19d, 19b), wherein one clamping jaw (19a) is placed on the protective disc (27) while the other clamping jaw (19b) Is placed on the glass disc (1).

6. Photovoltaic module according to one of the claims 1 to 4, **characterized in that** it is fastened to a substructure by means of a module clamp (13) comprising a single clamping jaw (19a), wherein the protective disc (27) rests directly on the substructure.

7. The photovoltaic module according to claim 6, **characterized in that** the protective disc (27) has a vertically-protruding centering mandrel (37) which is inserted into a recess (39) of a module carrier rail (35) of the substructure which prevents the photovoltaic module from slipping.

8. The photovoltaic module according to claim 6 or 7, **characterized in that** the protective disc (27) comprises two webs (41a, 41b) extending in parallel, wherein the spacing (A) between them corresponds to the width of a module carrier rail (35) of the substructure.

9. Photovoltaic module according to one of the claims 1 to 8, **characterized in that** a distance between 2 mm and 20 mm is maintained between the protective disc (27) and the longitudinal edge (9).

## Revendications

1. Module photovoltaïque de forme rectangulaire, sans châssis, avec une première surface externe (1) en verre et avec une deuxième surface externe (3) en matière plastique, formant une barrière contre l'humidité, moyennant quoi, sur la surface externe (3) en matière plastique, au niveau des deux arêtes longitudinales (9), plus particulièrement à partir de l'intérieur, une plaque de protection (27) recouvrant une zone de serrage prédéterminée est reliée de manière ferme et durable avec la surface externe en matière plastique (3), **caractérisé en ce que** la plaque de protection (27) est constituée d'acier, d'aluminium, de carbone, de téflon, d'une matière plastique dure, de verre ou de céramique.

2. Module photovoltaïque selon la revendication 1, **caractérisé en ce que**, par arête longitudinale (9) deux plaques de protection (27) sont prévues, dont une est placée après environ un quart de la longueur de l'arête longitudinale et l'autre est placée après environ trois quarts de la longueur de l'arête longitudinale.

3. Module photovoltaïque selon la revendication 1 ou 2, **caractérisé en ce que** les bords de la plaque de protection (27) sont au moins partiellement biseautés.

4. Module photovoltaïque selon l'une des revendications 1 à 3, **caractérisé en ce que** la plaque de protection (27) est munie, au niveau des deux angles de son arête longitudinale orientée vers l'arête du module (9), d'un moulage d'égouttage (49).

5. Module photovoltaïque selon l'une des revendications 1 à 4, **caractérisé en ce qu'**il est fixé, au moyen d'une chambre de module (13) comprenant deux mâchoires de serrage (19a, 19b), dont une mâchoire de serrage (19b) est placée sur la plaque de protection (27) et l'autre mâchoire de serrage (19a) est placée sur la plaque de verre (1), à une infrastructure.

6. Module photovoltaïque selon l'une des revendications 1 à 4, **caractérisé en ce qu'**il est fixé, au moyen d'une chambre de module (13) comprenant une seule mâchoire de serrage (19a) à une infrastructure, la plaque de protection (27) étant posée directement sur l'infrastructure.

7. Module photovoltaïque selon la revendication 6, **caractérisé en ce que** la plaque de protection (27) comprend un mandrin de centrage (37) perpendiculaire, qui est inséré dans un évidement (39) d'un montant de support du module (35) de l'infrastructure, et qui sécurise le module photovoltaïque contre un glissement.

8. Module photovoltaïque selon la revendication 6 ou 7, **caractérisé en ce que** la plaque de protection (27) comprend deux nervures (41a, 41b) dont la distance (A) entre elles correspond à la largeur d'un montant de support du module (35) de l'infrastructure.

9. Module photovoltaïque selon l'une des revendications 1 à 8, **caractérisé en ce que**, entre la plaque de protection (27) et l'arête longitudinale (9), une distance entre 2 mm et 20 mm est maintenue.
